# EUROPEAN PATENT APPLICATION

(11) **EP 4 339 339 A1**
(43) Date of publication of application: **20.03.2024**
(21) Application number: 22195693.1
(22) Date of filing: 14.09.2022
(51) Int. Cl.: C30B 29/04, C30B 33/06

(54) **BONDING OF DIAMOND PIECES TO SILICON SUBSTRATES USING A FLOWABLE BONDING AGENT**

(71) Applicant: Nederlandse Organisatie voor toegepast-natuurwetenschappelijk Onderzoek TNO, 2595 DA 's-Gravenhage (NL)
(72) Inventor: TSAPANOU-KATRANARA, Eftychia, 2595 DA Den Haag (NL); PAPADOPOULOS, Nikolas, 2595 DA Den Haag (NL); VOLLMER, René, 2595 DA Den Haag (NL)
(74) Representative: V.O.

(57) **Abstract**

The invention is directed to a method to attach a diamond slice to a carrier substrate, in particular to a method to attach a diamond slice to a carrier substrate by applying a flowable bonding agent. The invention is further directed to a device comprising an attached diamond slice to a carrier substrate and to a method for detaching a diamond slice from such a device.

## Description

The invention is directed to a method to attach a diamond slice to a carrier substrate, in particular to a method to attach a diamond slice to a carrier substrate by applying a flowable bonding agent. The invention is further directed to a device comprising an attached diamond slice to a carrier substrate and to a method for detaching a diamond slice from such a device.

It is known that diamond has favorable properties for many applications, such as quantum computing, power electronics, sensors and optics. In order to optimize on these properties, diamond slices are often functionalized and processed to fabricate diamond chips. Due to the small size and transparency of the diamond slices, it may however be challenging to fabricate the chips. An option may be to bond the diamond slice to a larger substrate to facilitate handling.

An example describing direct bonding of a diamond piece to a substrate is provided by Matsumea et al. (Scripta Materialia 175, 2020, 24-28). Herein a monocrystalline diamond substrate was bonded with a silicon substrate by annealing at low temperatures under atmospheric conditions. The substrate surfaces were functionalized with hydroxyl groups and bonded through dehydration reactions. However, this requires acid treatment and involves a complicated multi-step procedure in a clean environment, which procedure is sensitive to defects and contamination. Additionally, any impurities on the surfaces prevent correct bonding of the diamond slice onto the substrate. Further, the diamond and substrate surfaces may not be too rough.

Another method for direct bonding is described by Tao, Y. and Degen, C. (Adv. Mater. 2013, 25, 3962-3967). Herein a diamond sheet is bonded to an oxide-bearing silicon carrier using hydrogen silsesquioxane resist as the bonding agent. The oxide wafer chip is spin coated with the hydrogen silsesquioxane, followed by deposition of the diamond film. The bonding developed after 30 minutes under pressures higher than 10 kPa and at 500 °C. Disadvantageously, it is required to apply a high pressure and temperatures of 500 °C or higher to allow for bonding. This not only requires very specific systems to enable such high temperature and pressures, but also by the application of the pressure, the top surface of the diamond slice may be contaminated or damaged. In addition, the high temperature can be a limiting factor for specific applications. Tao, Y. and Degen, C. further describe the precleaning with piranha acid for 40 minutes.

Other methods to attach a diamond slice to a carrier substrate include using organic resists. These organic resists typically comprise polymers such as, but not exclusively, poly(methyl methacrylate) PMMA. However, harsh acid treatments that are required for surface cleaning may damage such organic resists or epoxies to such an extent that the diamond slice has to be laboriously, and typically manually, reattached to a substrate after each treatment. Additionally, detaching the diamond chip from the substrate may comprise placing the device in a solvent in which the organic resist is dissolved and the bond is broken. However, it may be challenging to retrieve the diamond chip from this solvent as it is poorly visible and detectable due to its small size and transparency.

It is an object of the present inventors to provide a method that overcomes at least part of the above-mentioned drawbacks. The present inventors found that using a flowable bonding agent comprising a silsesquioxane under new conditions than those previously reported allows for an improved method to bond a diamond slice to a carrier substrate. Additionally, the use of such a bonding agent allows for an easy detaching method.
Figure 1A illustrates a side view of a carrier substrate having a receiving top surface;
Figure 1B illustrates a side view of a carrier substrate comprising a layer of a bonding agent;
Figure 1C illustrates a side view of a device comprising a diamond slice attached to a carrier substrate using a layer of a bonding agent;
Figure 2 illustrates a top view of a device comprising a diamond slice attached to a carrier substrate using a layer of a bonding agent;
Figure 3 illustrates a side view of a device that has been diced.

Thus, in a first aspect, the present invention is directed to a method for attaching a diamond slice to a carrier substrate, such as a silicon carrier substrate. The method comprises:
- applying a layer of a flowable bonding agent comprising a silsesquioxane on at least part of a receiving top surface of the carrier substrate;
- placing the diamond slice on the layer; and
- curing the layer comprising heating to a final temperature between 250 and 450 °C to attach the diamond slice to the carrier substrate.

It was found that a diamond slice attached to a carrier substrate according to the first aspect results in a bond that can withstand shear loads, acid treatments and immersion into cryogenic liquids such as liquid helium. Additionally, the devices fabricated by this method may advantageously be used for quantum computing, semiconducting, photonic or magnetic elements.

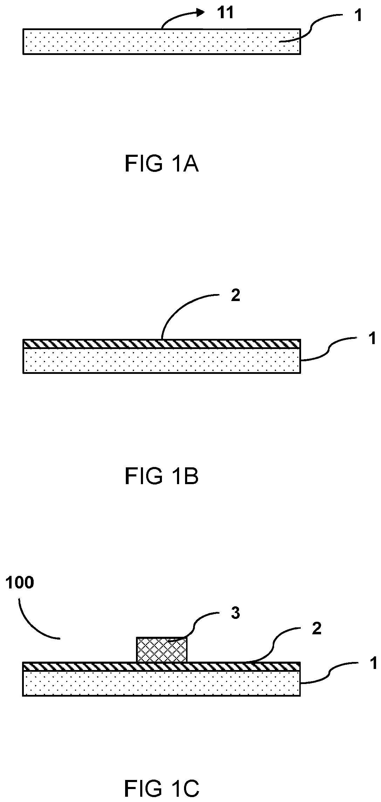

The carrier substrate typically comprises a dielectric, semiconducting and/or metallic materials. Suitable carrier substrates may comprise silicon, such as silicon wafers, which are commercially available. A schematic representation of a suitable carrier substrate is provided in Figure 1A. The receiving top surface (11) of the carrier substrate (1) may be considered as the surface onto which the layer is applied and the diamond slice is placed.

The term 'flowable' with respect to flowable bonding agent is known in the art and may be used to describe that the bonding agent has a sufficiently low viscosity, such that the bonding agent at least partially spreads out over the substrate after application. In other words, the flowable bonding agent is fluidic and not solid. The sufficiently low viscosity is typically required at ambient temperature (roughly 21 °C). However, it may be useful to slightly warm up the carrier substrate and/or the bonding agent in order to achieve the optimal viscosity and flowability of the bonding agent. The viscosity allows for an improvement in the smoothness of the resulting layer, filling of gaps in the substrate and covering small protrusions in the carrier substrate. The bonding layer is typically directly contacting the receiving top surface of the carrier substrate. The flowable bonding agent may thus compensate for any inconsistencies in height present on the receiving top surface of the carrier substrate. The bonding agent may accordingly also be suitably used for surface planarization and may form a uniform layer on the carrier substrate. Such uniform layer of the bonding agent is illustrated in Figure 1B, wherein the layer of a bonding agent (2) is provided on the receiving top surface of the carrier substrate (1).

Suitable bonding agents comprise a silsequioxane. Silsequioxanes are silicon compounds typically having a general formula [RSiO_{3/2}]ₙ, wherein R may be *e.g.* H, alkyl, aryl or alkoxyl. Silsequioxanes may have cage-like structures and Si-O-Si bonds and may be cured by at least partial rearrangement to a network (see *e.g.* Yang et al., J. Mater. Chem., 2002, 12, 1138-1141). Preferably, the bonding agent comprises a hydrogen silsesquioxane (HSQ)(*i*.*e*. [HSiO_{3/2}]ₙ). In order to be sufficiently flowable, the HSQ may be present in a solution. The solvent present in the solution is preferably evaporated during curing. Accordingly, it is particularly preferred that the bonding agent comprises HSQ and a volatile solvent. Such bonding agents may allow for optimal surface planarization and controlled layer thickness. An example of such a bonding agent is the commercially available FOx^{®} (flowable oxide) by Dow Corning. FOx^{®} is available with many carrier solvent systems, for instance methyl isobutyl ketone (typically referred to as FOx-1x^{®}), or methyl siloxane fluid blend (typically referred to as FOx-2x^{®}).

The layer of the bonding agent may be applied on at least part of the receiving top surface of the carrier substrate. As the carrier substrate may be larger than the diamond slice, it may not be required to apply the layer on the entire receiving top surface of the carrier substrate. Preferably the layer is applied on at least the part of the receiving top surface of the carrier substrate that receives the diamond slice. Accordingly, all of the bottom surface of the diamond slice preferably contacts the layer of the bonding agent. It may be appreciated that, depending on the size of the carrier substrate and the application method, more of the receiving top section may be covered by the layer of the bonding agent. The layer may be applied by any suitable means known in the art, typically by using conventional spin-on glass equipment. Preferably, the layer is applied by spin-coating.

The thickness of the applied layer may depend on several factors such as the surface roughness and/or cleanliness of the receiving top surface of the carrier substrate. In case there is a large deviation in height over the receiving top surface of the carrier substrate, a thicker layer may be preferred to compensate for this deviation. On the other hand, if the receiving top surface of the carrier substrate is very smooth, the layer of the bonding agent may be thinner. The receiving top surface of the carrier substrate may also have some impurities that may dictate the preferred thickness of the layer. The method may therefore also comprise cleaning the receiving top surface of the carrier substrate prior to applying the bonding agent. Cleaning may be executed by using acetone, isopropanol and/or by using acids, such as sulfuric acid, hydrochloric acid and/or nitric acid. Advantageously, clean with harsh conditions such a piranha acid (*i.e.* a mixture of sulfuric acid and hydrogen peroxide) is not required. Generally, the bonding layer is applied to obtain a layer having a thickness of at least 100 nm, preferably between 100-5000 nm, preferably between 200-2000 nm. A thicker layer may provide a stronger bond and more substrate defect tolerance. However, the thicker the layer, the higher the risk of cracking may be. Additionally, a thicker layer may affect the thermal conductivity. Accordingly, a more preferable layer thickness may be between 200-750 nm. Typically, the bonding layer is applied to obtain a layer having a thickness between 220-650 nm, such as between 550-650 nm or between 220-370 nm.

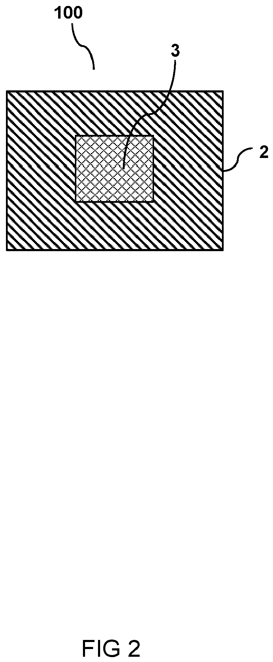

The method according to the first aspect allows for an easy process to robustly attach a diamond slice to a carrier substrate to allow for easier handling of the diamond slice. The diamond slice is therefore placed on the layer of the bonding agent. This is illustrated in Figure 1C. Figure 1C provides a side view of a device (100) according to a second aspect (*vide infra*)*,* comprising the carrier substrate (1) with a layer of the bonding agent (2), whereon the diamond slice (3) is placed. A top view is provided in Figure 2.

It is preferred that the diamond slice is a single crystal diamond (*e.g.,* (100), (111), (110)), as this provides the best properties for final applications. The diamond slice is typically not functionalized, however, the method may also suitably be used for a functionalized diamond slice. The term 'functionalized' relating to the diamond slice is herein used to describe that the diamond slice has been processed and treated to be used for the desired application (*e.g.* for quantum computing applications). Functionalization may result in the formation of a diamond chip. It may be appreciated that the bonding properties may also depend on the surface orientation of the surface of the diamond slice that is placed onto the layer of bonding agent. Accordingly, placing the diamond slice may comprise placing a bottom surface of the diamond slice on the layer. The bottom surface is accordingly the surface that comes into contact with the layer of the bonding agent. The top surface, opposite to the bottom surface, may be the surface that is further functionalized. Preferably the bottom surface comprises a diamond (100) surface, a diamond (110) surface or a diamond (111) surface. It may also be appreciated that the bottom surface may comprise an at least partial coating covering the diamond surface. In such cases, the bottom surface may still be considered to comprise the diamond (100) surface, the diamond (110) surface or the diamond (111) surface. For some quantum applications, it is preferred that the bottom surface of the diamond is a diamond (111) surface. For some other quantum or sensing applications the diamond (100) surface is preferred. The numbers in brackets, *e.g.* (111), represent Miller indices.

As illustrated in the Figures, the diamond slice is typically smaller than the carrier substrate. The top surface of the diamond slice may be less than 1 mm², but preferably the top surface of the diamond slice has a surface area between 1 mm² and 50 mm², preferably between 1 mm² and 25 mm², more preferably between 1 mm² and 9 mm². Typically, the top surface of the diamond slice has a square or rectangular shape. For many applications, the top surface of the diamond slice has a surface area of around 4 mm², for instance approximately 2 by 2 mm for a square or slightly rectangular shaped top surface.

The thickness of the diamond slice may be dependent on the final application. In preferred embodiments the thickness of the diamond slice is between 0.1 pm and 1 mm. The invention can for instance be applicable to thin diamond membranes. Typically a thickness of the diamond slice between 50 and 550 pm is preferred. For some quantum applications it may be preferred that the thickness of the diamond slice is between 200 and 500 µm. In some cases it may also be preferred to have thin diamond slice (*e.g.* a diamond membrane), having a thickness of between 1 and 15 µm, such as between 8 and 13 pm, or approximately 10 µm.

Following the placement of the diamond slice, the layer is cured. Curing of the layer comprises heating to a final temperature between 250 and 450 °C. Advantageously, curing the layer may not require applying high pressures. For instance, no pressure or a small pressure by hand may suffice. This pressure may be applied on only the corners and/or edges, for instance by using tweezers or a cotton swab. A small force may also be applied by a gas stream, such as a nitrogen gas stream, on the top surface of the diamond slice, optionally while holding the edges of the diamond slice. There is thus typically no need for a plate to press onto the surface of the top surface of the diamond slice with pressures such as 10 kPa. Accordingly, contamination of the top surface (*i.e.* the surface that may be further functionalized) may be minimized, thereby reducing the need for cleaning steps. Additionally, a diamond slice that has been functionalized to have connections, nodes, *etc.,* may be (re)attached to a carrier substrate without damaging the functionalization. Further, no particular equipment capable of providing high pressures and high temperatures is required.

The heating may be performed by placing the composition (*i.e.* at least the carrier substrate, layer and diamond slice) on a hot plate. Heating allows for the silsesquioxane to rearrange and form new network bonds and for the optional solvent to evaporate, such that the diamond slice is bonded to the carrier substrate. In case the curing is performed at a temperature above 360°C, the amount of Si-H bond dissociation due to oxidation may decrease very rapidly with temperature. In order for the bonding to be optimized, the heating may be gradual. This may be best achieved in an oven, such as a vacuum oven. The pressures in a vacuum oven may be approximately 10⁻² mbar. Gradually increasing the temperature allows for the solvent to evaporate before the silsesquioxane starts to crosslink into a single macroscopic material. Accordingly, the heating may comprise gradually increasing the temperature with a gradient between 5 and 8 °C. The optimal gradient may depend on the applied thickness of the layer. For a thicker layer, a slower increase in temperature is preferred as this allows for less strain on the carrier substrate and the diamond slice. It is preferred that the heating comprises gradually increasing the temperature with a gradient between 6 and 7 °C per minute. It may be that the gradient is not fully linear, in such cases, the gradient may be considered an average gradient, wherein the average gradient is calculated by dividing the total temperature increase by the total residence time (*i.e.* the time the composition is heated).

Further, the final temperature also plays a role in the final bonding properties. A low temperature is typically preferred as this limits the equipment requirements, and increases the time efficiency. Additionally, a high temperature may minimize the application possibilities, while a too low temperature may not be sufficient to fully cure the layer. A final temperature between 250 and 450 °C, more preferably between 300 and 400 °C, such as between 350 and 400 °C, was found to result in optimum adhesion. The obtained adhesion may withstand blade dicing, cryogenic liquid immersion, spin coating, and/or strong acid treatments.

A second aspect of the present invention is directed to a device obtainable by the method according to the first aspect. This device comprises a diamond slice attached to a carrier substrate. A side view of a suitable device (100) is provided in Figure 1C. A top view is provided in Figure 2. The diamond slice (3) is attached through a layer of a cured bonding agent (2), wherein the bonding agent comprises a silsesquioxane.

The device may be suitable for many applications such as power electronics, photonic applications and for quantum computing applications. It may be appreciated that in order to be used for these applications, it may be required to functionalize the diamond slice. Functionalization may include cleaning and fabricating nodes around lattice defects. Accordingly, the diamond slice comprised by the device may be a functionalized diamond slice.

A third aspect of the present invention is directed to the preparation of the device for quantum computing applications. For such applications the diamond slice may have controlled defects. These defects may be atomic-scale defects, such as a nitrogen vacancy. Such diamond slices may be commercially available. However, it is required to locate the defects in order to use them for the applications. Locating these defects requires handling of the diamond slice, which is made easier by attaching it to a carrier substrate in accordance with the method according to the first aspect.

Functionalization of the diamond slice such that it becomes suitable for quantum applications may not only require finding suitable defects, but also making a node around such a defect such that the defect may function as desired. Making such a node includes cleaning, patterning, etching, and other nanofabrication steps known in the state of the art. It was found that the bond between the diamond slice and the carrier substrate can withstand such strong acids, making the device according to the second aspect highly suitable for use in the aforementioned applications.

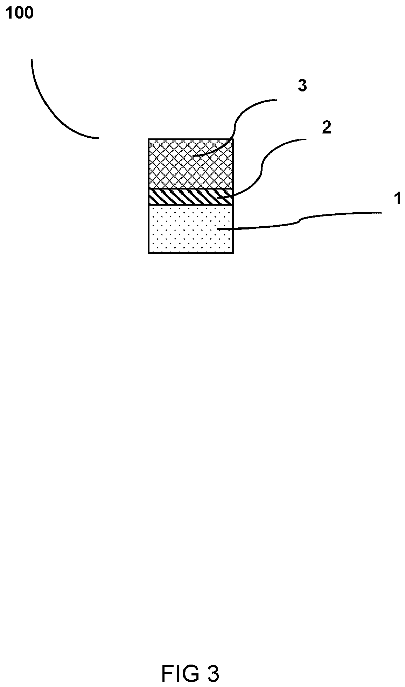

The strong bond further allows for the device to be diced, e.g. using blade dicing, without breaking the bond between the carrier substrate and the diamond slice. Dicing is used to describe a process wherein the device is cut to remove any material around the diamond slice, while the diamond slice remains bonded to the carrier substrate. Thus, in other words, leaving a stack of a carrier substrate, bonding layer and the diamond slice, approximately having a footprint of the size of the surface area of the top surface of the diamond slice. An illustration of a side view of a device (100), comprising the, optionally functionalized, diamond slice (3), the bonding layer (2) and the carrier substrate (1) that has been diced is provided in Figure 3.

A fourth aspect is directed to a method for detaching a functionalized diamond slice from a device according to the third aspect. The diamond slice is accordingly processed and treated to be suitably used as a diamond chip, for instance for quantum computing applications. It was found that all that is required to detach the functionalized diamond slice is a thermal shock. The method accordingly comprises providing a thermal shock to the device. The method provides a quick, on-demand and easy way to retrieve the functionalized diamond slice. Without wishing to be bound by theory, the thermal shock is believed to induce an increase in stress, via a temperature gradient, on the bonding layer, such that the bonding layer cracks and the functionalized diamond slice is released. The thermal shock may result in the expansion of the bonding layer, which is not compensated by the functionalized diamond slice, such that the induced stress allows for cracking of the bonding layer and the loss of adhesion. In order to optimally use the feature that the bonding layer expands while the functionalized diamond slice does not, the thermal shock is preferably a directional thermal shock. Typically in the direction from the bottom of the device (*i.e.* the side that does not comprise the diamond slice) towards the top of the device (*i.e.* the side that does comprise the diamond slice).

The thermal shock may be provided by any suitable means, such as by placing the device on a hot plate, using a heat gun, and/or by a Peltier element. The thermal shock should be sufficient to provide stress on the bonding layer, that is not compensated for by the functionalized diamond slice. Accordingly, the thermal shock is typically provided by increasing the temperature within seconds, such as within 10 or 5 seconds, from ambient temperatures to a temperature up to 250 °C. To make the debonding happen more rapidly, the device may be pre-cooled prior to applying the thermal shock. Accordingly, the method may further comprise pre-cooling the device to a temperature between -10 and 10 °C prior to providing the thermal shock.

The detached diamond slice may thus be a functionalized diamond slice that can be used in *i.a.* printed circuit boards.

It may be appreciated that a combination of the above-mentioned aspects may also be employed. Accordingly the present invention is further directed to a method for preparing a functionalized diamond slice. The method comprises:
- attaching a diamond slice to a carrier substrate according to the method of the first aspect;
- functionalizing the diamond slice to obtain a functionalized diamond slice;
- detaching the functionalized diamond slice according to the method of the fourth aspect.

In order for the functionalized diamond slice to be suitable for quantum computing applications, the functionalizing may comprise locating atomic-scale defects, for instance nitrogen vacancies, and fabricating nodes around these defects using standard micro- and nano-lithographic fabrication techniques known in the state of the art.

The present invention thus allows for easy functionalization of diamond slices to obtain functionalized diamond slices through bonding of a diamond slice to carrier substrates under more mild temperatures and pressures and under less rigorously clean environments relative to other published methods. The diamond slice becomes more easy to handle as the carrier substrate is typically larger than the diamond slice and more readily visible by eye. The bonding quality is good, and may withstand shear loads, harsh acid treatments and cryogenic temperatures. Its application for easier fabrication of diamond chips is facilitated through the easy detaching method, which allows fabrication on a separate substrate from the final use-case.

For the purpose of clarity and a concise description, features are described herein as part of the same or separate embodiments, however, it will be appreciated that the scope of the invention may include embodiments having combinations of all or some of the features described.

## Claims

1. Method for attaching a diamond slice to a carrier substrate, such as silicon carrier substrate, wherein the method comprises:
- applying a layer of a flowable bonding agent comprising a silsesquioxane on at least part of a receiving top surface of the carrier substrate;
- placing the diamond slice on said layer; and
- curing the layer comprising heating to a final temperature between 250 and 450 °C to attach the diamond slice to the carrier substrate.

2. Method according to the previous claim, wherein the heating comprises gradually increasing the temperature with a gradient between 5 and 8 °C per minute, preferably between 6 and 7 °C per minute.

3. Method according to any of the previous claims wherein the final temperature is between 300 and 400 °C.

4. Method according to any of the previous claims, wherein the bonding agent comprises a hydrogen silsesquioxane, most preferably the bonding agent comprises a solution comprising a hydrogen silsesquioxane.

5. Method according to any of the previous claims, wherein the bonding agent is applied to obtain a layer having a thickness of at least 100 nm, preferably between 100 and 5000 nm, more preferably between 200 and 2000 nm, even more preferably between 200-750 nm, most preferably between 220-650 nm.

6. Method according to any of the previous claims, wherein the diamond slice has a top surface area of between 1 mm² and 50 mm², preferably between 1 mm² and 25 mm², more preferably between 1 mm² and 9 mm².

7. Method according to any of the previous claims, wherein placing the diamond slice comprises placing a bottom surface of the diamond slice on the layer wherein the bottom surface comprises a diamond (100) surface, a diamond (110) surface or a diamond (111) surface, preferably a diamond (111) surface.

8. Device comprising a diamond slice, which is optionally functionalized, attached to a carrier substrate obtainable by the method according to any of the previous claims.

9. Device according to the previous claim, wherein the layer of the bonding agent has a thickness of at least 100 nm, preferably between 100 and 5000 nm, more preferably between 200 and 2000 nm, even more preferably between 200-750 nm, most preferably between 220-650 nm

10. Use of the device according to the any of the previous claims 8-9 for quantum computational applications.

11. Method for detaching a functionalized diamond slice from a device according to any of claims 8-9, wherein the method comprises providing a thermal shock to the device, preferably a directional thermal shock.

12. Method according to the previous claim, wherein the method further comprises pre-cooling the device to a temperature between -10 and 10 °C prior to providing the thermal shock.

13. Method for preparing a functionalized diamond slice, wherein the method comprises:
- attaching a diamond slice to a carrier substrate according to the method of any of claims 1-7;
- functionalizing the diamond slice to obtain a functionalized diamond slice;
- detaching the functionalized diamond slice according to the method of any of claims 11-12;
preferably wherein the functionalizing comprises:
- locating an atomic-scale defect, such as a nitrogen vacancy, in the diamond slice;
- fabricating a node around the atomic-scale defect.
